# EUROPEAN PATENT APPLICATION

(11) **EP 2 385 150 A1**
(43) Date of publication of application: **09.11.2011**
(21) Application number: 10004722.4
(22) Date of filing: 05.05.2010
(51) Int. Cl.: C23C 14/02, C23C 16/48, C30B 28/00, C23C 14/22, H01L 39/24

(54) **Method for the production of biaxially textured films and films obtained using such a method**

(71) Applicant: ETH Zurich, 8092 Zürich (CH)
(72) Inventor: Seita, Matteo, 8057 Zürich / ZH (CH); Zeng, Ke, 8051 Zürich / ZH (CH); Spolenak, Ralph, 8103 Unterengstringen / ZH (CH)

(57) **Abstract**

Disclosed is a method for producing a biaxially textured film (10) on a substrate (1) comprising the steps of: i) deposition of a uniaxially textured film (4, 7) on the substrate (1); ii) ion bombardment (3) of the uniaxially textured film (4, 7) with an irradiation angle (α) relative to the normal (12) to the plane of the substrate at the point of irradiation in the range of 10-80° until only nanocrystals having essentially the same out-of-plane and in-plane orientation remain in the film (4, 7) essentially over the full thickness (13) of the film (4, 7); wherein this sequence of steps i) and ii) is repeated until a biaxially textured film (10) which is essentially in-plane continuous is formed. The correspondingly produced biaxially textured films show uniform texture over the full thickness of the film layer and can be used for many applications such as microelectronics applications.

## Description

### TECHNICAL FIELD

The invention relates to biaxially textured thin films, as well as to methods for making such films and to devices and systems made therefrom such as interconnects for microelectronics or thin metal films for micro-electro-mechanical systems (MEMS).

### PRIOR ART

Reliability is a key issue in the fabrication of micro- and nanosystems: the most common causes of failure (e.g. fatigue, creep, or electromigration) are strongly related to the microstructure of the material. Single crystal materials are known to show better performance and higher reliability compared to their polycrystalline counterparts. However, the prohibitive cost associated with the direct processing of single crystal materials is one of the limiting factors to the implementation of single crystals as materials for e.g. interconnects in microelectronics, micromirrors employed for micro- electro-mechanical systems (MEMS) or interdigitated metal lines for acoustic sensor transducers. Ion-bombardment assisted deposition (IBAD) has been widely reported in literature as a valid and affordable technique to grow biaxially textured thin films. The method comprises the deposition of a thin film by means of evaporation, chemical vapor deposition (CVD) or sputter deposition and one or more impinging ion-sources employed during deposition and directed at a specific angle with respect to the substrate.

However, processing biaxially textured films by IBAD is usually associated with the synthesis of high temperature superconductor films, which need to have in-plane and out-of-plane crystallographic texture spreading of less than 20 degrees in order to match the desired current densities, but do not impose any limitation on the number of metal layers employed in the final device. The process comprises the deposition of a uniaxially textured layer on an amorphous or polycrystalline substrate, followed by the deposition of a biaxially textured buffer layer by IBAD and then the epitaxial growth of the biaxially textured superconducting material. There are several issues which prevent the integration of this technique in microelectronic industry e.g. the presence of two buffer layers, that can be different in material, and would thereby show poorer performance as a conductor; the complexity of the process involving material deposition and ion irradiation interfering with each other; the inclusion of a high number of defects and voids upon IBAD of metal films and the degradation of the in-plane texture as the thickness of the IBAD film increases, see e.g. US2005205014 disclosing dual ion beam assisted deposition of biaxially textured template layers.

For the mentioned reasons, a more suitable method for producing biaxially textured films to be integrated in microelectronic industry involves post-deposition ion-bombardment of the film.

US5795385 discloses a method of producing biaxially textured substrates and related articles, devices and systems. Specifically a method of producing single crystalline Si-based semiconductor thin films by ion-bombardment is disclosed. They induce both out-of plane and in-plane textures in amorphous or polycrystalline Si-based films by using multi ion-beams which re-arrange the atomic structure at the film surface without inducing sputtering of the material. Once the film surface is converted to a single crystal, this layer is used as seed for the re-crystallization of the deep portion of the film enabled by heat treatment. The whole film results single crystal oriented provided that the annealing temperature is below the crystallization temperature of the Si-based material. However, this method only allows the growth of single crystalline semiconducting materials and not metallic materials. In fact, in order to re-crystallize the deep portion of the deposited Si-film according to the biaxially textured top surface seed layer, said deposited film must be initially amorphous; a status which is essentially impossible to attain with pure metallic materials. Moreover, it only comprises CVD based systems, which are not as commonly used as PVD-based methods and do not lead to comparable deposition rates.

Another technique disclosed in W02006/060008 relates to biaxially-textured substrates and related articles, devices and systems and methods for producing the same. It involves the post-deposition ion-bombardment of uniaxially textured films (e.g. nickel) epitaxially grown on a uniaxially textured buffer layer similar in lattice constant but not necessarily of the same material. The film deposition is carried out by means of pulsed laser deposition. The ion-beam induces an exclusively surfacial in-plane texture in the very surface of the top metal layer through a selective sputtering process. Ion-bombardment is followed by epitaxial deposition of the same metal on said ion-bombarded surface resulting in a biaxially textured metal film. The main disadvantage of this method is in the inhomogeneity of the biaxially textured film, which shows a biaxially textured top layer grown on a uniaxially textured buffer layer; not to mention the increased film roughness arising after depositing the thin film on the ion-bombarded surface of the buffer layer.

### SUMMARY OF THE INVENTION

It is therefore an object of the present invention to provide a new and improved method for the production of biaxially textured films, for examples of applications in the microelectronics field, as well as correspondingly made biaxially textured films and applications thereof.

Specifically, the present invention presents a method for producing a biaxially textured film on a substrate comprising the steps of:
i) deposition of a uniaxially textured film on the substrate;
ii) ion bombardment of the uniaxially textured film with an irradiation angle relative to the normal to the plane of the substrate/film at the point of irradiation in the range of 10-80° until only nanocrystals having the same out-of-plane and in-plane orientation remain in the film and this not only on the surface but essentially over the full thickness of the film, preferably over the complete and full thickness of the film, i.e. down to the very substrate; wherein this sequence of steps i) and ii) is repeated until a biaxially textured film which is essentially in-plane continuous (forming an essentially continuous and/or contiguous layer on the surface in the area to be coated) is formed.

In other words a method for producing biaxially textured thin films on a substrate is proposed comprising:
a first step consisting of a sequence of deposing a uniaxially textured film followed by ion-bombardment of the deposed film along a specific direction inducing selective sputtering and leaving a number of isolated nanocrystals having the same out-of-plane and in-plane orientation, this sequence being repeated until a biaxially textured film of desired thickness is attained and an optional second step consisting of epitaxial growth of material on top of the biaxially textured film.

So according to a first preferred embodiment of the proposed method on top of the biaxially textured film further material is deposited in a process of epitaxial growth.

The proposed method for producing biaxially textured films comprises a substrate and a first thin film deposited onto it preferably by a physical or chemical deposition technique, the mentioned thin film having uniaxial texture characterized by out-of-plane texture with no significant in-plane crystallographic texture. Therefore such a film according to a preferred embodiment and normally shows a crystallographic misorientation from grain-to-grain of less than 30 degrees, preferably of less than 20°, along the out-of-plane direction, but essentially random crystallographic orientation along whatever in-plane direction. The aforementioned film shows uniaxial texture already after deposition without additional treatments. The aforementioned uniaxially textured film is then ion-bombarded preferably along a specific crystallographic direction which leads to selective sputtering of the grains composing the film through the whole film thickness. The process results in the formation of a number of isolated nanocrystals having the same out-of-plane and in-plane texture i.e. being biaxially textured. Said in-plane texture shows a crystallographic misorientation from grain-to-grain of less than 30 degrees, preferably of less than 20°.

The same material used to deposit the first uniaxially textured film is preferentially again deposited on top of such biaxially textured nanocrystal formation, which acts as seed, resulting in the nucleation of new grains with the same biaxial texture. The repetition of the steps: i) deposition of the same material and ii) ion bombardment leads to the synthesis of biaxially textured continuous films. The thickness of said biaxially textured continuous film can be 50, 100 or 200 nm. Epitaxial growth of thicker films on top of said biaxially textured continuous film can be carried out with essentially no degradation of the biaxial texture and with whatever deposition technique. Therefore for the described method no particular requirements of film thickness are needed.

This method for producing biaxially textured films does not involve the use of high temperature treatments nor the presence of specific substrates provided that uniaxially textured films can be grown.

Epitaxial growth of the same material on the ion-bombarded biaxially textured seed layer is not hindered by usage of high deposition rate techniques such as sputter deposition or evaporation. Therefore this method only requires the inclusion of few additional steps and of an ion-source installed in the deposition reactor chamber in order to produce high performance biaxially textured films. For this reason the described method for producing biaxially textured films is of easy integration in microelectronic industry where large production and fast processing of materials is required.

According to yet another preferred embodiment, in at least one of steps i), preferably in all steps i) if a sequence is carried through, the irradiation angle is chosen along a specific crystallographic direction, which is normally in the range of 20-60°, preferably in the range of 30-40°, most preferably at an angle of 35° or of 45°.
as mentioned above, it is possible to deposit on top of the biaxially textured film further material in a process of epitaxial growth, wherein the further material is preferably the same as the material used in step i).

Preferentially, the material of the uniaxially textured film created in step i) is a metal or an alloy, wherein preferably it is selected from a transition metal, more preferably selected from the group of copper, silver, gold, or the group of nickel, palladium, platinum, or a combination thereof.

According to yet another preferred embodiment of the method according to the invention, the deposition in step i) takes place by physical vapour deposition, chemical vapour deposition, electrodeposition or electroless deposition, wherein in a sequence of steps i) preferably the same deposition technique is used.

Preferably the thickness of the film produced in the initial step i) is above 50 nm, preferably in the range of 50 nm - 2 µm, more preferably in the range of 100 nm-1 µm. This is typically also approximately the thickness of the final contiguous layer obtained at the end of the sequence of steps i)/ii). This layer thickness can be increased by the above-mentioned epitaxial growth wherein the mentioned contiguous layer acts as a seed layer, allowing for final layer thicknesses of up to 10 µm.

According to yet another preferred embodiment of the method, in step ii) an ion fluence in the range of 10^IS-10^20 ions/cm2, preferably in the range of 10^16-10^18 ions/cm2 is applied. This high fluence makes sure that indeed during step ii) the nano crystals the in plane orientation of which are not as desired are completely sputtered away over the full layer thickness and not only as a very surfacial region thereof.

According to another preferred embodiment of the method, in step ii) an irradiation energy in the range of 0.5-10 keV, preferably in the range of 4-7 keV is applied. Also the duration of irradiation should be adapted so as to make sure that indeed during step ii) the nano crystals the in plane orientation of which are not as desired are completely sputtered away over the full layer thickness and not only as a very surfacial region thereof.

The speed of the selective sputtering process generally depends on the ion current density. The energy of the ion beam is preferably in the order of a few keV, in particular 5 keV.

Preferably, in step ii) Argon atoms are used for the ion bombardment step. The above-mentioned fluence/energy values preferably apply for using argon atoms and will have to be adapted correspondingly as well known to the person skilled in the art if different atoms are used for the bombardment step.

According to a preferred embodiment, the uniaxially textured film is made from an f.c.c. material characterized by (111) out-of-plane texture and wherein the irradiation angle of the ion bombardment is equal to an angle of 35 degrees with respect to the normal of the film surface.

In the alternative, the uniaxially textured film is made from an f.c.c. material characterized by (100) out-of-plane texture and wherein the irradiation angle of the ion bombardment is equal to an angle of 45 degrees with respect to the normal of the film surface.

The uniaxially textured film can also be made from a b.c.c. material characterized by (110) out-of-plane texture, wherein the irradiation angle of the ion bombardment is equal to an angle of 35 degrees with respect to the normal of the film surface.

In other words, the first uniaxially textured film is in general a cubic material, in particular an f.c.c. or b.c.c. metal, in particular gold, silver or nickel. The initial film thickness can be of 50, 100 or 200 nm. The uniaxial texture of the f.c.c, film is characterized by a (111) or (100) out-of-plane texture and no significant in-plane crystallographic texture. The uniaxial texture of the b.c.c. film is characterized by a (110) out-of-plane texture and no significant in-plane crystallographic texture. The ion-beam is provided by an ion-gun installed in the deposition reactor so that contamination and/or oxidation of the film surface prior to the ion-irradiation is prevented. The ion-beam is set at a specific angle from the normal to the film surface; wherein said angle corresponds to the angular distance between the out-of plane texture crystallographic orientation of the film and a second crystallographic direction of choice; wherein the second crystallographic direction of choice along which the ion-beam is set is a channeling axis for the film material, in particular the main channeling axis of the cubic material. Said channeling axis can be the <110> crystallographic direction for f.c.c. films or the <111> crystallographic direction for b.c.c. films. Therefore the ion-beam set at the aforementioned impinging angle with respect to the normal to the film surface "selects" out of the uniaxially textured film a subset of grains having the aforementioned channeling axis parallel to the ion-beam impinging direction. The "selection" is provided from the random in-plane crystallographic orientation of the grains composing the uniaxially textured film. Said random in-plane crystallographic orientation always allows the ion-beam to find a subset of grains having the aforementioned channeling axis parallel to the ion-beam impinging direction. The aforementioned subset of grains "selected" by the ion-beam having a channeling axis parallel to the ion-beam impinging direction have a lower sputter yield compared to the remaining grain fraction; therefore said remaining grain fraction is sputtered faster than the aforementioned "selected" subset of grains. The difference in sputter yield results in the formation of a number of isolated nanocrystals on the substrate surface having the same out-of-plane and in-plane texture i.e. being biaxially textured. Said out-of-plane and in-plane textures show a crystallographic misorientation from grain-to-grain of less than 30 degrees. The degree of biaxial texture can be evaluated by specifying the full-width-half maximum (FWHM) of the grain out--of-plane and in-plane orientation distributions as determined from the electron back scattered diffraction (EBSD) characterization.
As mentioned above, it is possible to deposit on top of the biaxially textured film further material in a process of epitaxial growth, preferably using the same material as used to the making of the uniaxially textured film, leading to a total biaxially textured layer thickness of in the range of 0.05-10 µm, preferably in the range of 0.2-5 µm.

The following advantages of the proposed method can be identified:
1. The described method allows for tuning the microstructure of polycrystalline thin films along the whole film thickness into biaxially textured materials by means of low energy and low cost ion-irradiation process; and can thereby be easily integrated in standard microfabrication technology. Said method does not involve the use any additional buffer layer nor ion beam concurrent to the deposition process (IBAD) and is in particular not restricted to any particular class of materials.
2. Reliability is a key issue in the fabrication of micro- and nanosystems: the most common causes of failure (e.g. fatigue, creep, or electromigration) are strongly related to the micro-structure of the material. Single crystal materials are known to show better performance and higher reliability compared to their polycrystalline counterparts. However, the prohibitive cost associated with the direct processing of single crystal materials is the limiting factor to their implementation in microelectronic industry. The aforementioned biaxially textured thin films resulting from the method invented here will show better performance compared to the polycrystalline materials commonly used (e.g. metallic lines with lower electrical resistance, less deformation caused by residual stresses and higher electromigration resistance).
3. Ion-bombardment assisted deposition (IBAD) has been widely reported in literature as a valid and affordable technique to grow biaxially textured thin films. The method comprises the deposition of a thin film by means of evaporation, chemical vapor deposition (CVD) or sputter deposition and one or more impinging ion-sources employed during deposition and directed at a specific angle with respect to the substrate. However, processing biaxially textured films by IBAD is usually associated with the synthesis of high temperature superconductor films, which need to have in-plane and out-of-plane crystallographic texture spreading of less than 20 degrees in order to match the desired current densities, but do not impose any limitation on the number of metal layers employed in the final device. The process comprises the deposition of a uniaxially textured layer on an amorphous or polycrystalline substrate, followed by the deposition of a biaxially textured buffer layer by IBAD and then the epitaxial growth of the biaxially textured superconducting material. There are several issues which prevent the integration of this technique in microelectronic industry e.g. the presence of two buffer layers, that can be different in material, and would thereby show poorer performance as a conductor; the complexity of the process involving material deposition and ion irradiation interfering with each other; the inclusion of a high number of defects and voids upon IBAD of metal films and the degradation of the in-plane texture as the thickness of the IBAD film increases.
4. In contrast to the solutions proposed in the state of the art: the invented method does not require particular buffer layers; it is not restricted to special classes of materials provided that said materials can grow uniaxially textured; it does not require heat treatments; the application of the described method is not limited to films up to a certain thickness: the biaxial texture does not degrade for increasing film thicknesses; the treatment induces a biaxial texture in the deposited film along the whole thickness and not only on at the material surface; in order to be integrated in microelectronic industry, the inclusion of few additional steps is only required; unlike IBAD, the method described decouples the effects of the deposition flux of atoms from the ion-beam; it does not require any peculiar deposition technique provided that a uniaxially textured film can be deposited; it does not comprise ion-beam reflectors or mirrors to focus the ions on the film, which reduces the probabilities of cross-contamination; it can be employed on film stacks which include e.g. adhesion layers with properties different than the biaxially textured film.

Furthermore the present invention relates to biaxially textured films obtained using a method as described above, preferably with a thickness of at least 50 nm, preferably at least 100 nm, most preferably with a total thickness in the range of 100 nm - 500 nm. The present invention also relates to stack of films including at least one such film, preferably for microelectronics applications.

Furthermore the present invention relates to the use of a method as outlined above for the production of metal films, in particular for microelectronics applications such as interconnects for microelectronics or metal films for micro electro mechanical systems, micromirrors employed for micro- electro-mechanical systems or interdigitated metal lines for acoustic sensor transducers.

To summarize, at least the following differences between the proposed method and the methods according to the state-of-the-art can be given:
- The method can in principle work for every crystalline material provided that said material can grow uniaxially textured
- The method does not require heat treatments, preferably it is carried out without any heat treatment
- The method does not comprise any particular substrates or necessary additional buffer layers
- The method can lead to high deposition rates
- The application of the described method is not strongly limited to films up to a certain thickness: the biaxial texture does essentially not degrade for increasing film thicknesses
- The treatment induces a biaxial texture in the deposited film over the whole thickness
- The integration of the method in microelectronic industry is possible, if necessary with the addition of few additional steps only in the already established processes.
- Unlike in IBAD the method described decouples the effects of the deposition flux of atoms from the ion-beam
- The method does not require any particular deposition technique provided that a uniaxially textured film can be deposited
- The method does not require ion-beam reflectors or mirrors to focus the ions on the film; this reduces the probabilities of cross-contamination, preferably it is carried out without such elements
- The method works with metallic materials and therefore does not require the presence of neutralizers at the output of the ion-gun
- The method can be employed on film stacks which include e.g. adhesion layers

Further embodiments of the invention are laid down in the dependent claims.

### BRIEF DESCRIPTION OF THE DRAWINGS

Preferred embodiments of the invention are described in the following with reference to the drawings, which are for the purpose of illustrating the present preferred embodiments of the invention and not for the purpose of limiting the same. In the drawings,

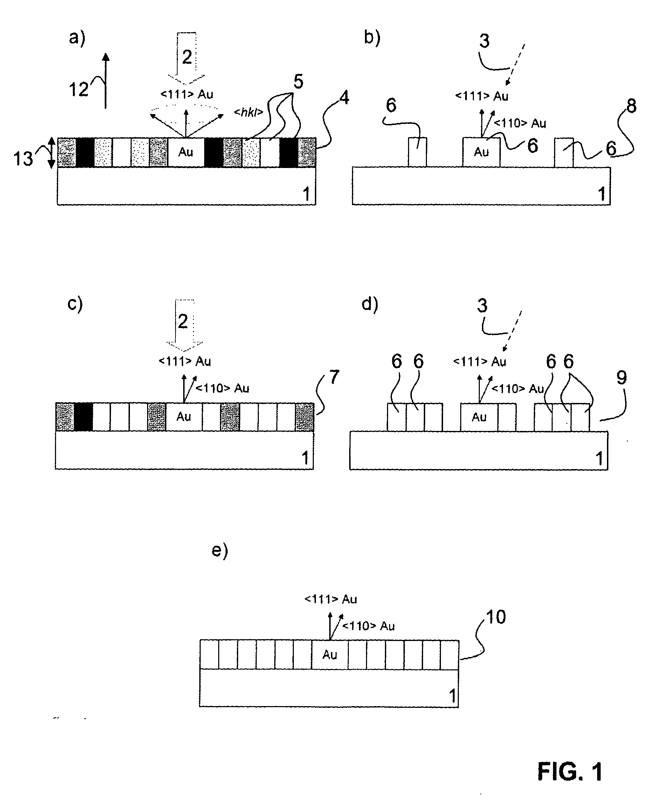

- Fig. 1: shows steps in a general method for forming biaxially textured films through a process of ion bombardment induced selective sputtering of said film grains and redeposition of the same material, wherein a) illustrates a uniaxially textured first gold film after deposition, b) shows the biaxially textured nano crystals after ion gun treatment, c) shows a second film after a second deposition step with increased in plane texture; d) shows the film according to c) after second ion gun treatment and e) shows a final continuous film of columnar grains of uniform out-of-plane texture and inplane texture;
- Fig. 2: illustrates a setup according to an embodiment of the invention, wherein the initial uniaxially textured film is made of an f.c.c. material and is characterized by a (111) out-of-plane texture;

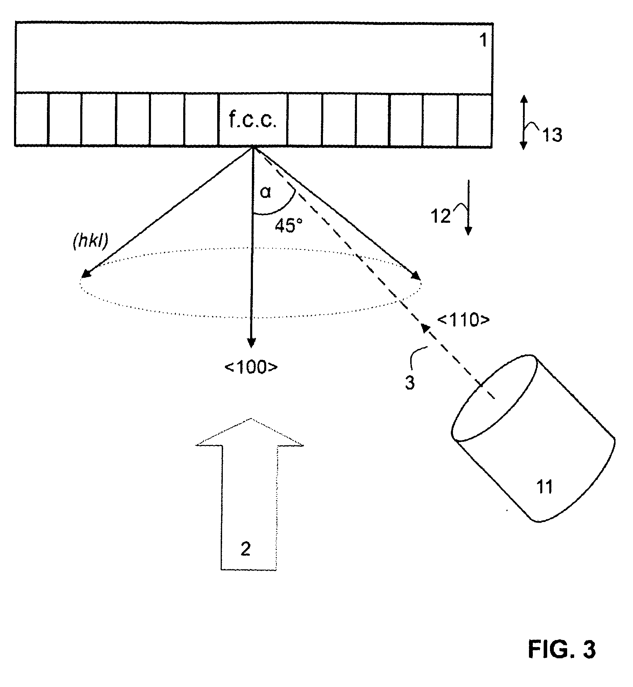

- Fig. 3: illustrates a setup according to an embodiment of the invention, wherein the initial uniaxially textured film is made of an f.c.c. material and is characterized by a (100) out-of-plane texture;

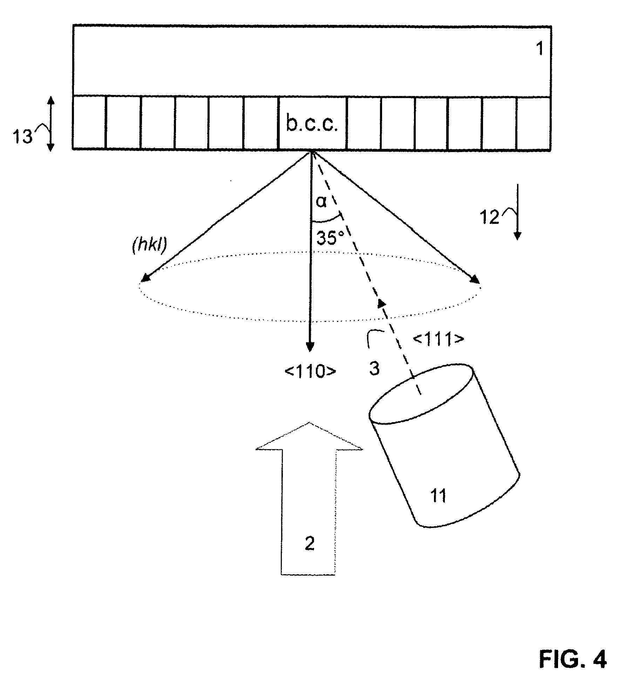

- Fig. 4: illustrates another setup according to another embodiment of the invention, wherein the biaxially textured film is made of a b.c.c. material and is characterized by a (110) out-of-plane texture; and

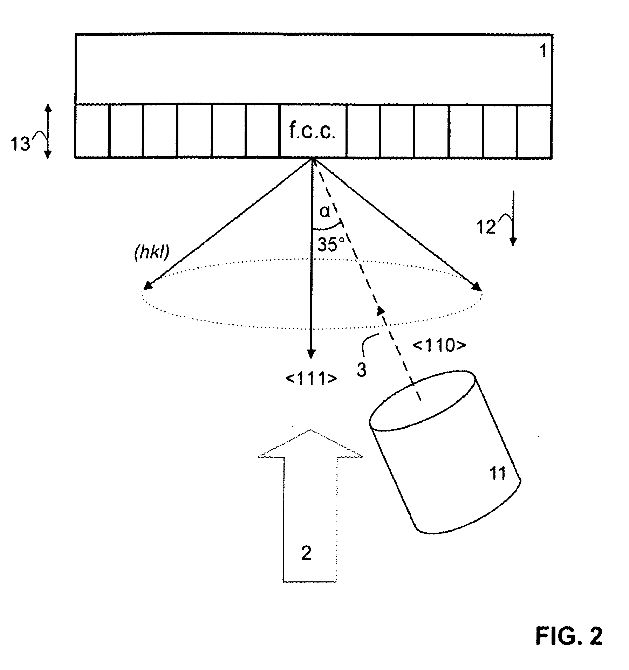

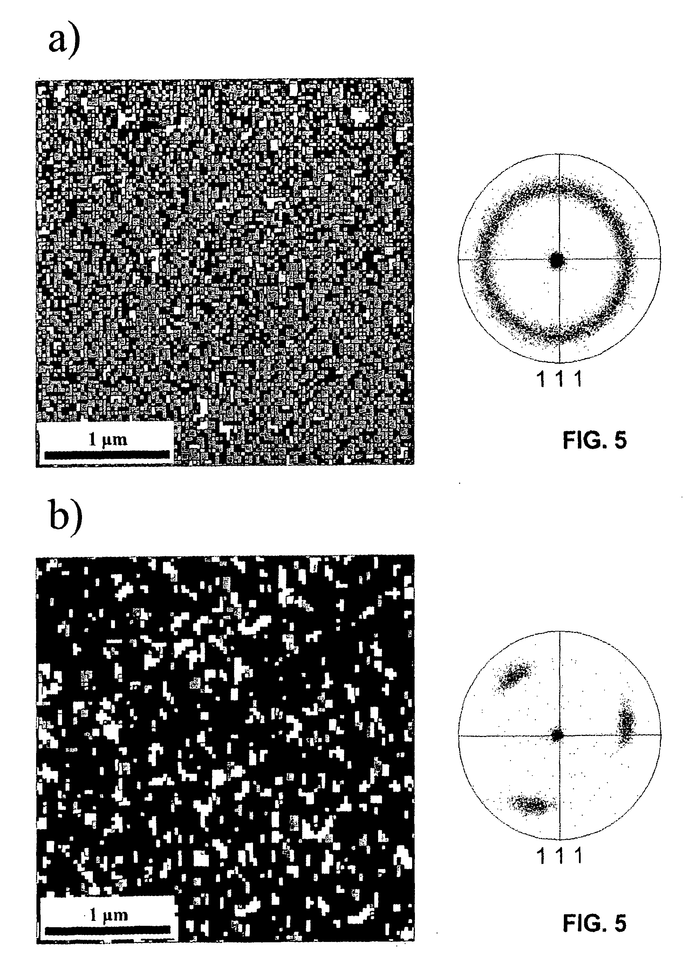

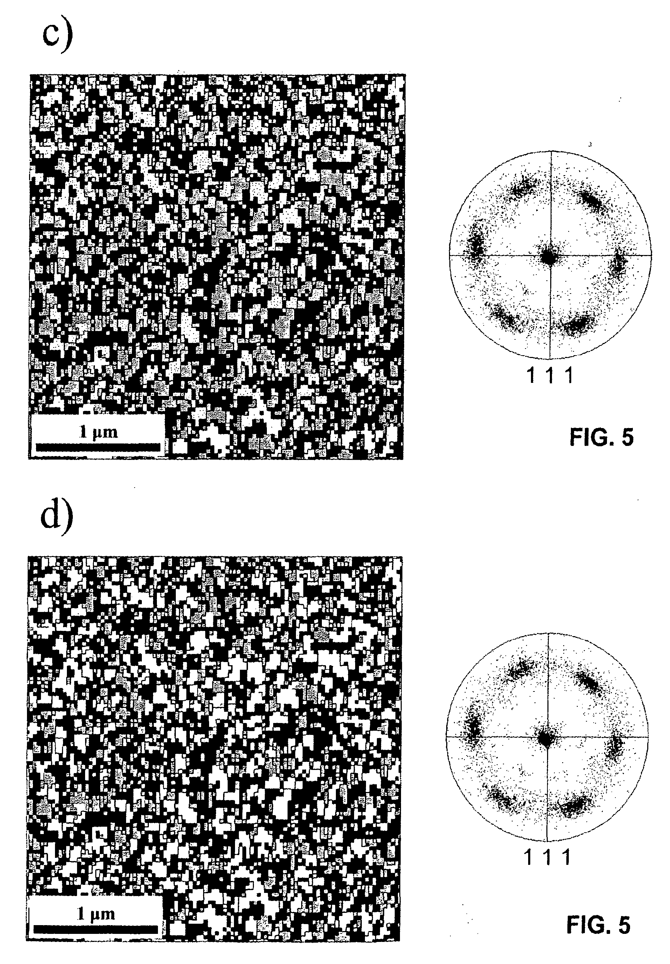

- Fig. 5: illustrate EBSD characterizations of a sample area of gold film after inducing a biaxial texture as a result of a process like in figures 2, wherein specifically EBSD orientation maps and Pole Figures of a sample area from a 50 nm thick gold film after inducing a biaxial texture are given; the diagrams on the left side show randomly oriented grains in grey shade and the ion beam selected subset of grains in white colour, and the right hand side shows the corresponding Pole Figures at three different steps of the whole process, namely: a) after deposition, where the film shows the initial uniaxial (111) texture normal to the sample surface and an essentially complete random in-plane alignment; b) after ion-bombardment, where the only grains surviving the ion-induced etching process are the ones aligned for channeling; c) after a subsequent deposition of 50 nm of gold on top of the seed nanocrystallites; d) same as c) but considering the twinned orientations formed after the subsequent redeposition.

### DESCRIPTION OF PREFERRED EMBODIMENTS

Referring to figure 1, a first uniaxially textured thin film with f.c.c. structure and a thickness of 50 nm is magnetron sputtered on a silicon substrate covered by two layer stack of SiO₂ and Si₃N₄ both of 50 nm in thickness. The film material can be for instance gold, silver or nickel. The uniaxial textured is characterized by a strong (111) out-of-plane texture corresponding to a crystallographic misorientation from grain-to-grain of less than 30 degrees along the out-of-plane direction, but random crystallographic orientation along whatever in-plane direction. The film grain structure consists of columnar grains with aspect ratio close to 1. Figure la illustrates the uniaxially textured gold film after deposition. The complete random in-plane orientation distribution from grain-to-grain is represented by the different grain color shades from black to white. According to theory uniaxial texture formation is contributed by grain growth velocity anisotropy between various crystal faces of grains on the surface of the films. Grains oriented to have fast grain growth direction lying not only normal to the film surface but also along the surface normal are preserved while, consequently, slower growing grains are terminated. Surface energy minimization is commonly thought to be responsible for the (111) out-of-plane texture in f:c.c. metals and (110) out-of-plane texture in b.c.c. metals as (111) and (110) planes are the most densely packed atomic configurations for f.c.c. and b.c.c. materials, resulting in the lowest surface energy.

Said uniaxially textured f.c.c. film is then irradiated by means of an ion-gun directly installed in the reactor chamber as shown figure 2. The ion-beam energy is set at 5 keV with an impinging direction of 35 degrees to the normal of the f.c.c. film surface. The angular distance from the film normal axis corresponds to that between (111) and (110) crystal planes, <110> being the main channeling direction for f.c.c. materials. As the irradiation continues, a process of selective sputtering of the gold grains results in the formation of isolated nanocrystals having the same out-of-plane and in-plane texture i.e. being biaxially textured. The selective sputtering derives from the difference in sputter yield between grains having the <110> channel axis aligned parallel to the ion beam and the randomly oriented remaining grain fraction. Said subset of grains having the <110> channel axis aligned parallel to the ion beam show lower sputter yield and therefore result in the aforementioned biaxially textured nanocrystals formation. This step is illustrated in figure 1b.

Following the step illustrated in figure 1, redeposition of 50 nm gold film on the biaxially textured nanocrystal formation leads to an increased of the total in-plane film texture as schematically shown in figure 1c where the number of grains having the <110> channel axis aligned parallel to the ion beam (in white color shade) increases significantly compared to the as-deposited state of the f.c.c. film.

Additional irradiation and redeposition steps result again in the selective sputtering of the fewer and fewer grains which have an in-plane misorientation spread with respect to the biaxially textured nanocrystal formation higher than 30 degrees (figure ld) and a progressively improved in-plane texture of the whole film. The final situation is illustrated in figure le, wherein the f.c.c. film is continuous and biaxially textured.

Once a continuous biaxially textured film is formed, deposition of thicker films on top of said biaxially textured film is possible without degradation of the biaxial texture for thicknesses of e.g. 200 nm. Therefore the aforementioned biaxially textured thin film as produced through the process of the ion-irradiation induced selective sputtering and redeposition of the same material acts as seed layer for further epitaxial growth. The described method could be integrated in microelectronic industry to be used for the deposition of biaxially textured copper interconnects. Until now, the established technique to deposit copper interconnects comprises the sputter deposition of a polycrystalline seed layer of copper followed by a massive electrodeposition of the same material. Biaxially texturing the sputter-deposited copper layer by means of the described invention would lead to high performance and reliable interconnects at the cost of integrating few additional steps in the microfabrication process.

Fig. 5 illustrates EBSD characterizations of a sample area of a gold film after inducing a biaxial texture as a result of a process like in figures 2. Specifically EBSD orientation maps and Pole Figures of a sample area from a 50 nm thick gold film after inducing a biaxial texture are given; the diagrams on the left side show randomly oriented grains in grey shade and the ion beam selected subset of grains in white color, and the right hand side shows the corresponding Pole Figures at three different steps of the whole process, namely: a) after deposition, where the film shows the initial uniaxial (111) texture normal to the sample surface and an essentially complete random in-plane alignment. The percentage of biaxially textured material in this case is 15%; b) after ion-bombardment, where the only grains surviving the ion-induced etching process are the ones aligned for channeling (the percentage of biaxially textured material here is 76%); c) after a subsequent deposition of 50 nm of gold on top of the seed nanocrystallites (the percentage of biaxially textured material is 39% here); d) same as c) but considering the twinned orientations formed with after the subsequent redeposition, leading to a percentage of biaxially textured material of 63%.

As one can see from figure 5 a) representing measurements on the textured film prior to the first time carrying out step ii), there is a high degree of uniaxial texture in the out of plane direction giving rise to the strong central peak in the pole figure on the right side indicating the (111) orientation of the crystallographic axis of the nano crystals deposited on the surface. On the other hand the in-plane orientation of the nano crystals is essentially completely random giving rise to the circular distribution of dots around the central peak maximum in the polar diagram on the right hand side. The representation on the left side shows the microstructure of the deposited film. Among the nanocrystalline grains represented in uniform grey shade, a subset of grains having the same crystallographic orientation within 20 degrees of tolerance is depicted in white color.

If on such a layer 4 the above-mentioned step ii) of ion bombardment is carried out, essentially all those nano crystals which are not aligned with their crystallographic axis in the proper orientation relative to the irradiation direction will be sputtered away.

The corresponding resulting film 8 or rather the corresponding distribution of individual columnar nano crystalline structures sitting on top of the surface is analyzed leading to the representations given in figure 5 b). As one can see there is still a high homogeneity in the out of plane distribution (see narrow width of central peak in the pole figure on the right side), and a very high homogeneity also in the in-plane orientation as can be seen in the significantly more uniform left diagram, where the amount of randomly oriented grains (in grey) is strongly reduced in favor of a very high percentage of white colored grains (the increase in black areas comes from the absence of material from which the EBSD evaluation could derive information of crystallographic orientation), and by the fact that from the circular distribution of points around the central peak in the pole figure of figure 5a now only a subset is selected giving rise to the three off centre spots in the pole figures on the right hand side of figure 5b. After a second redeposition step (second time step i) a film as documented in figures 5c) and 5d) results. The out-of plane distribution remains essentially the same (see central spot in the pole figure on the right) while the in-plane distribution (left diagram) becomes somewhat more distributed but is still focused due to the seeded growth during the deposition assisted by the columnar structures generated in the first cycle of steps i) and ii). That in the pole figure on the right hand side of figure 5c there is not only three but six off centre peaks is due to the fact that in this experiment gold is used forming twinned structures. To quantify the efficiency of the seeded growth after steps i), ii) and again i), one can refer to Figure 5d, where together with the channeling oriented grains, also the twinned grains have been highlighted in white color.

### LIST OF REFERENCE SIGNS

- I: substrate
- 2: film deposition flux
- 3: ion bombardment beam
- 4: first thin-film
- 5: columnar grains of uniform out of plane texture and random in plane texture
- 6: biaxially textured nano crystals
- 7: second thin-film with increased in plane texture
- 8: discontinuous film of columnar grains of uniform out of plane texture and in plane texture after the first
- 9: ion beam treatment discontinuous film of columnar grains of uniform out of plane texture and in plane texture after the second ion beam treatment
- 10: continuous film of columnar grains of uniform out of plane texture and in plane texture
- 11: ion gun
- 12: normal to the plane
- 13: thickness of the film

- α: irradiation angle of 3

## Claims

1. Method for producing a biaxially textured film (10) on a substrate (1) comprising the steps of
i) deposition of a uniaxially textured film (4, 7) on the substrate (1);
ii) ion bombardment (3) of the uniaxially textured film (4, 7) with an irradiation angle (α) relative to the normal (12) to the plane of the substrate at the point of irradiation in the range of 10-80° until only nanocrystals having essentially the same out-of-plane and in-plane orientation remain in the film (4, 7) essentially over the full thickness (13) of the film (4, 7);
wherein this sequence of steps i) and ii) is repeated until a biaxially textured film (10) which is essentially in-plane continuous is formed.

2. Method according to claim 1, wherein on top of the biaxially textured film (10) further material is deposited in a process of epitaxial growth.

3. Method according to any of the preceding claims, wherein in at least one of steps i), preferably in all steps i) the irradiation angle (α) is chosen to be in the range of 30-60°, preferably in the range of 30-40°, most preferably at an angle of 35° or of 45°.

4. Method according to any of the preceding claims, wherein on top of the biaxially textured film (10) further material is deposited in a process of epitaxial growth, wherein the further material is the same or different material as the material used in step i).

5. Method according to any of the preceding claims, wherein the material of the uniaxially textured film (4, 7) created in step i) is cubic material and/or a metal or an alloy, wherein preferably it is selected from a transition metal, more preferably selected from the group of copper, silver, gold, or the group of nickel, palladium, platinum, or a combination thereof.

6. Method according to any of the preceding claims, wherein the deposition in step i) takes place by physical vapour deposition, chemical vapour deposition, electrodeposition or electroless deposition, wherein in a sequence of steps i) preferably the same deposition technique is used.

7. Method according to any of the preceding claims, wherein the thickness (13) of the film (4, 7, 10) is above 50 nm, preferably in the range of 50 nm - 2 µm, more preferably in the range of 100 nm - 1 µm.

8. Method according to any of the preceding claims, wherein in step ii) a fluence in the range of 10¹⁵-10²⁰ ions/cm², preferably in the range of 10¹⁶_10¹⁸ ions/cm² is applied and/or wherein in step ii) an irradiation energy in the range of 3-10 keV, preferably in the range of 4-7 keV is applied.

9. Method according to any of the preceding claims, wherein in step ii) Argon atoms are used for the ion bombardment step.

10. Method according to any of the preceding claims, wherein the uniaxially textured film (4,7) is made from an f.c.c. material **characterized by** (111) out-of-plane texture and wherein the irradiation angle (α) of the ion bombardment is equal to an angle of 35 degrees with respect to the normal (12) of the film surface, or wherein the uniaxially textured film (4, 7) is made from an f.c.c. material **characterized by** (100) out-of-plane texture and wherein the irradiation angle (α) of the ion bombardment is equal to an angle of 45 degrees with respect to the normal (12) of the film surface.

11. Method according to any of the preceding claims, wherein the uniaxially textured film (4, 7) is made from a b.c.c. material **characterized by** (110) out-of-plane texture and wherein the irradiation angle (α) of the ion bombardment is equal to an angle of 35 degrees with respect to the normal (12) of the film surface.

12. Method according to any of the preceding claims, wherein on top of the biaxially textured film (10) further material is deposited in a process of epitaxial growth, preferably using the same material as used to the making of the uniaxially textured film (4, 7), leading to a total biaxially textured layer thickness of in the range of 0.05-10 µm, preferably in the range of 0.2-5 µm.

13. Biaxially textured film (10) obtained using a method according to any of the preceding claims, preferably with a thickness (13) of at least 50 nm, preferably at least 100 nm, most preferably with a thickness (13) in the range of 100 nm - 500 nm.

14. Stack of films including at least one film according to claim 13, preferably for microelectronics applications.

15. Use of a method according to claims 1-12 for the production of metal films, in particular for microelectronics applications such as interconnects for microelectronics or metal films for micro electro mechanical systems, micromirrors employed for micro- electro-mechanical systems or interdigitated metal lines for acoustic sensor transducers.
